# EUROPÄISCHE PATENTANMELDUNG

(11) **EP 4 776 840 A1**
(43) Veröffentlichungstag der Anmeldung: **15.07.2026**
(21) Anmeldenummer: 26151436.8
(22) Anmeldetag: 12.01.2026
(51) Int. Cl.: H10W 74/10, H10D 80/20, H10W 70/01, H10W 70/692, H10W 72/00

(54) **LEISTUNGSMODUL UND VERFAHREN ZUR HERSTELLUNG EINES LEISTUNGSMODULS**

(30) Priorität: 14.01.2025 DE 102025101192
(71) Anmelder: Volkswagen Aktiengesellschaft, 38440 Wolfsburg (DE)
(72) Erfinder: Bayer, Christoph Friedrich, 38440 Wolfsburg (DE)

(57) **Zusammenfassung**

Die Erfindung betrifft ein Leistungsmodul (1), umfassend einen Träger (2), wobei der Träger (2) eine Keramik (3) und eine strukturierte Metallisierung (4) aufweist, wobei auf der strukturierten Metallisierung (4) mindestens ein Leistungshalbleiter (7) und mindestens ein Lastanschluss (6) angeordnet sind, wobei das Leistungsmodul (1) mindestens teilweise von einem Isolationsmaterial (10) umhüllt ist, wobei auf der strukturierten Metallisierung (4) mehrere Bonddrähte (8) angeordnet sind, wobei die Bonddrähte (8) mit beiden Enden jeweils auf einer gemeinsamen Struktur (9) der strukturierten Metallisierung (4) befestigt sind, sowie ein Verfahren zur Herstellung eines solchen Leistungsmoduls (1).

## Beschreibung

Die Erfindung betrifft ein Leistungsmodul und ein Verfahren zur Herstellung eines Leistungsmoduls.

Solche Leistungsmodule finden beispielsweise im Automotive-Bereich Anwendung oder im Energie-Bereich, beispielsweise in Windkraftanlagen.

Die Leistungsmodule umfassen einen Träger, der eine Keramik als Isolationsschicht aufweist, auf der eine strukturierte Metallisierung aufgebracht ist. Die Strukturierung erfolgt beispielsweise durch Ätzen oder andere Verfahren, sodass voneinander getrennte Strukturen entstehen, die elektrisch getrennt sind. Auf der strukturierten Metallisierung ist mindestens ein Leistungshalbleiter angeordnet, der beispielsweise als Transistor ausgebildet ist (z.B. als MOSFET, IGBT oder GaN HEMT). Typischerweise sind mehrere Leistungshalbleiter auf der strukturierten Metallisierung angeordnet, die dann beispielsweise als mindestens eine Halbbrücke verschaltet sind. Elektrische Verbindungen zwischen den einzelnen Elementen können dabei durch Bonddrähte und/oder Leadframes erfolgen. Weiter weist das Leistungsmodul mindestens einen Lastanschluss auf, an den eine Hochvoltspannung angelegt werden kann. Typischerweise weist ein Leistungsmodul mehrere Lastanschlüsse auf. Zum mechanischen Schutz sind die Leistungsmodule mit einer Vergussmasse vergossen, die als Silikongel oder als härtere gießbare Kunststoffmischung (z.B. Epoxidharz mit Füllstoffen) ausgebildet ist. Alternativ ist ein Spritzpressen (transfer molding) bekannt, wo heiße Kunststoffverbundmaterialien in ein Werkzeug gepresst werden. Als Material für die Moldmasse werden hauptsächlich thermosetische Harze (z.B. Epoxidharze, Phenolharze, Polyesterharze, Melaminharze, Silikonharze) verwendet. Ein Problem bei solchen Leistungsmodulen ist die Haftung der Vergussmasse bzw. Transfermold mit dem Träger. Dabei kann es dazu kommen, dass sich zumindest partiell die Vergussmasse bzw. Transfermold löst, sodass Isolationsprobleme auftreten können z.B. durch Feuchtigkeit oder auch mechanische Probleme im Verbund des elektrischen Schaltkreises. Nachfolgend wird allgemein von Isolationsmaterial gesprochen, was sowohl eine Vergussmasse als auch ein Transfermold umfassen soll.

Aus der US 2019/0341366 A1 ist ein Halbleiterbauelement bekannt, das einen gestapelten Aufbau von Dies offenbart, wobei das Halbleiterbauelement auch mit einer Vergussmasse vergossen werden kann. Zur besseren mechanischen Befestigung der Dies auf dem Träger werden dort Dummy-Bonddrähte vorgeschlagen, die die Dies mit dem Träger verbinden, wobei diese Dummy-Bonddrähte nicht zur elektrischen Verbindung dienen.

Aus der US 5,780,772 A und der US 6,031,281 A sind jeweils mikroelektronische Schaltungen mit einer Vielzahl von Bonddrähten bekannt, wobei die Schaltungen jeweils mit einer Vergussmasse vergossen werden. Dabei werden zwischen den Bonddrähten Dummy-Bonddrähte angeordnet, die ein Verrutschen der Bonddrähte beim Vergießen verhindern sollen.

Der Erfindung liegt das technische Problem zugrunde, ein Leistungsmodul zu schaffen, bei dem die Haftung zwischen Träger und Vergussmasse verbessert ist, sowie ein entsprechendes Herstellungsverfahren zur Verfügung zu stellen.

Die Lösung des technischen Problems ergibt sich durch ein Leistungsmodul mit den Merkmalen des Anspruchs 1 sowie ein Herstellungsverfahren mit den Merkmalen des Anspruchs 7. Weitere vorteilhafte Ausgestaltungen der Erfindung ergeben sich aus den Unteransprüchen.

Das Leistungsmodul umfasst einen Träger, wobei der Träger eine Keramik und eine strukturierte Metallisierung aufweist. Auf der strukturierten Metallisierung sind mindestens ein Leistungshalbleiter und mindestens ein Lastanschluss angeordnet, wobei das Leistungsmodul von einem Isolationsmaterial umgeben ist. Dabei sind auf der strukturierten Metallisierung mehrere Bonddrähte angeordnet, wobei die Bonddrähte mit beiden Enden jeweils auf einer gemeinsamen Struktur der strukturierten Metallisierung befestigt sind. Durch diese Dummy-Bonddrähte, die nicht zur Signalführung dienen, verbindet sich das Isolationsmaterial (Vergussmasse oder Transfermold) an diesen Stellen besser mit dem Träger und die Gefahr des Lösens des Isolationsmaterials wird reduziert.

In einer Ausführungsform sind die Bonddrähte an den äußeren Rändern der strukturierten Metallisierung angeordnet, wobei die Bonddrähte vorzugsweise vollumfänglich auf der Metallisierung verteilt angeordnet sind.

In einer weiteren Ausführungsform sind die Bonddrähte an Kanten zwischen Strukturen der Metallisierung angeordnet.

In einer weiteren Ausführungsform sind die Bonddrähte um Funktionselemente des Leistungsmoduls angeordnet. Die Funktionselemente können beispielsweise die Leistungshalbleiter, Lastanschlüsse, Sensoren oder andere Bauteile sein. Dabei haben die Bonddrähte eine weitere Funktion und dienen auch dazu, die Funktionselemente geometrisch gegen ein Verschieben zu sichern, insbesondere wenn durch thermische Verfahrensschritte Lötverbindungen aufweichen können. Durch die Bonddrähte werden die Funktionselemente quasi lagefixiert.

In einer weiteren Ausführungsform ist das Isolationsmaterial, insbesondere das Transfermold, ein Epoxidharz, das beispielsweise durch thermisches Extrudieren das Leistungsmodul umhüllt.

In einer weiteren Ausführungsform sind die Bonddrähte aus Kupfer oder einer Kupferlegierung (z.B. mit Ti oder Si). Prinzipiell können diese aber auch aus Aluminium, einer Aluminiumlegierung, Gold oder Silber sein. Dabei kann auch vorgesehen sein, dass die Bonddrähte profiliert sind, d.h. beispielsweise Rillen aufweisen, an denen die Vergussmasse besser haften bleibt.

Das Verfahren zur Herstellung eines Leistungsmoduls umfasst als Verfahrensschritte, dass auf einem Träger aus einer Keramik mit einer strukturierten Metallisierung mindestens ein Leistungshalbleiter und mindestens ein Lastanschluss angeordnet werden. In einem Bondprozess werden mittels Bonddrähten elektrische Verbindungen zwischen Elementen des Leistungsmoduls hergestellt. Dabei sei angemerkt, dass die Lastanschlüsse auch erst nach dem Bondprozess aufgebracht werden können. Weiter werden auf der strukturierten Metallisierung mehrere Bonddrähte angeordnet, wobei die Bonddrähte mit beiden Enden jeweils auf einer Struktur der strukturierten Metallisierung befestigt werden. Abschließend wird das Leistungsmodul mit einem Isolationsmaterial umhüllt (vergossen oder transfergemoldet).

In einer Ausführungsform werden die mehreren Bonddrähte (also die Dummy-Bonddrähte zur Verbesserung der Haftung bzw. Lagestabilisierung) im Bondprozess für die elektrischen Verbindungen gebondet. Hierdurch wird die Fertigungszeit praktisch gegenüber herkömmlichen Verfahren nicht verändert.

In einer weiteren Ausführungsform werden die mehreren Bonddrähte an den äußeren Rändern der strukturierten Metallisierung und/oder an Kanten zwischen Strukturen der Metallisierung angeordnet.

In einer weiteren Ausführungsform werden die mehreren Bonddrähte um Funktionselemente des Leistungsmoduls angeordnet.

Die Erfindung wird nachfolgend anhand eines bevorzugten Ausführungsbeispiels näher erläutert. Die Figuren zeigen:
- Fig. 1: eine stark vereinfachte Seitenansicht eines Leistungsmoduls,
- Fig. 2: eine schematische Draufsicht auf einen Träger und
- Fig. 3: ein Flussdiagramm eines Verfahrens zur Herstellung eines Leistungsmoduls.

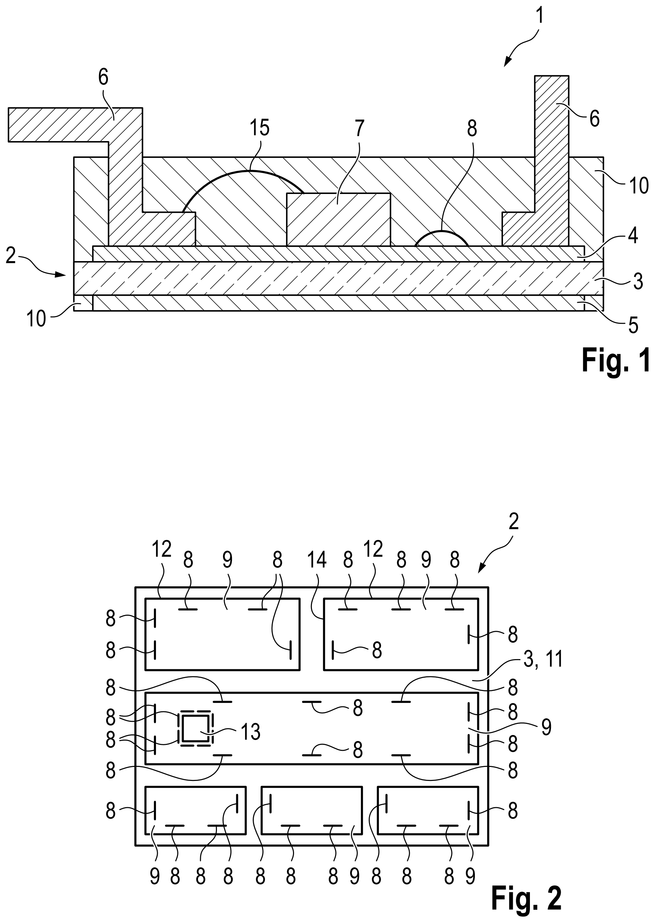

In der Fig. 1 ist stark vereinfacht ein Leistungsmodul 1 dargestellt. Das Leistungsmodul 1 weist einen Träger 2 auf, der als Isolationsschicht eine Keramik 3 aufweist, auf der eine strukturierte Metallisierung 4 aufgebracht ist. Auf der Unterseite der Keramik 3 ist eine weitere Metallisierung 5 aufgebracht, die beispielsweise zur thermischen Anbindung an einen nicht dargestellten Kühlkörper dient. Auf der strukturierten Metallisierung 4 sind zwei Lastanschlüsse 6 und mindestens ein Leistungshalbleiter 7 angeordnet. Dabei ist weiter dargestellt, dass mittels eines Bonddrahtes 15 eine elektrische Verbindung zwischen dem Leistungshalbleiter 7 und dem einen Lastanschluss 6 hergestellt ist. Weiter dargestellt ist einer von mehreren Bonddrähten 8, der mit beiden Enden auf einer Struktur 9 (siehe Fig. 2) der strukturierten Metallisierung 4 angeordnet ist. Das Leistungsmodul 1 ist mit einem Isolationsmaterial 10 umhüllt, wobei die Lastanschlüsse 6 teilweise aus dem Isolationsmaterial 10 herausragen.

In der Fig. 2 ist nun stark vereinfacht eine Draufsicht auf die strukturierte Metallisierung 4 des Trägers 2 dargestellt. Die strukturierte Metallisierung 4 weist voneinander getrennte Strukturen 9 auf, die durch Gräben 11 getrennt sind, wozu dort das Metall entfernt wurde. Am Boden der Gräben 11 ist dann die Keramik 3. An den äußeren Rändern 12 der strukturierten Metallisierung 4 sind die Bonddrähte 8 angeordnet, wobei diese vorzugsweise voll umfänglich angeordnet sind. Die Anzahl der Bonddrähte 8 ist dabei auch abhängig von dem verfügbaren Platz auf der Struktur 9 und kann variieren. Auch an Kanten 14 zwischen den Strukturen sind Bonddrähte 8 angeordnet. Die Bonddrähte 8 haben keine elektrische Funktion und dienen nur zur Verbesserung der Haftung des Isolationsmaterials 10 auf dem Träger 2. Weiter dargestellt ist, wie zusätzlich Bonddrähte 8 um ein Funktionselement 13 (z.B. ein Leistungshalbleiter 7) angeordnet sind. Diese Bonddrähte 8 haben die zusätzliche Funktion einer Lagestabilisierung des Funktionselements 13.

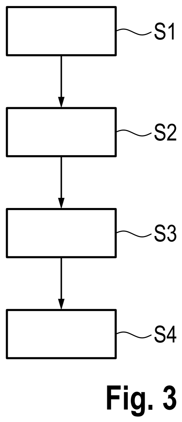

In der Fig. 3 ist ein Flussdiagramm des Verfahrens zur Herstellung eines Leistungsmoduls 1 dargestellt. In einem ersten Schritt S1 wird mindestens ein Leistungshalbleiter 7 auf eine strukturierte Metallisierung 4 eines Trägers 2 aufgebracht. Die Verbindung kann dabei eine Löt- oder Sinterverbindung sein. In einem zweiten Schritt S2 findet ein Bondprozess statt, bei dem mittels Bonddrähten 15 elektrische Verbindungen hergestellt werden. Gleichzeitig werden Bonddrähte 8 gebondet, die jeweils mit beiden Enden auf einer gleichen Struktur 9 befestigt werden. In einem dritten Schritt S3 werden dann Lastanschlüsse 6 mit der strukturierten Metallisierung 4 verbunden und anschließend in einem vierten Schritt S4 das Leistungsmodul 1 mit einem Isolationsmaterial 10 umhüllt wird.

### Bezugszeichenliste

- 1: Leistungsmodul
- 2: Träger
- 3: Keramik
- 4: strukturierte Metallisierung
- 5: Metallisierung
- 6: Lastanschluss
- 7: Leistungshalbleiter
- 8: Bonddraht
- 9: Struktur
- 10: Isolationsmaterial
- 11: Graben
- 12: äußerer Rand
- 13: Funktionselement
- 14: Kante
- 15: Bonddraht

## Patentansprüche

1. Leistungsmodul (1), umfassend einen Träger (2), wobei der Träger (2) eine Keramik (3) und eine strukturierte Metallisierung (4) aufweist, wobei auf der strukturierten Metallisierung (4) mindestens ein Leistungshalbleiter (7) und mindestens ein Lastanschluss (6) angeordnet sind, wobei das Leistungsmodul (1) mindestens teilweise von einem Isolationsmaterial (10) umhüllt ist,
**dadurch gekennzeichnet, dass**
auf der strukturierten Metallisierung (4) mehrere Bonddrähte (8) angeordnet sind, wobei die Bonddrähte (8) mit beiden Enden jeweils auf einer gemeinsamen Struktur (9) der strukturierten Metallisierung (4) befestigt sind.

2. Leistungsmodul (1) nach Anspruch 1, **dadurch gekennzeichnet, dass** die Bonddrähte (8) an den äußeren Rändern (12) der strukturierten Metallisierung (4) angeordnet sind.

3. Leistungsmodul (1) nach Anspruch 1 oder 2, **dadurch gekennzeichnet, dass** die Bonddrähte (8) an Kanten (14) zwischen Strukturen (9) der strukturierten Metallisierung (4) angeordnet sind.

4. Leistungsmodul (1) nach einem der vorangegangenen Ansprüche, **dadurch gekennzeichnet, dass** die Bonddrähte (8) um Funktionselemente (13) des Leistungsmoduls (1) angeordnet sind.

5. Leistungsmodul (1) nach einem der vorangegangenen Ansprüche, **dadurch gekennzeichnet, dass** das Isolationsmaterial (10) ein Epoxidharz ist.

6. Leistungsmodul (1) nach einem der vorangegangenen Ansprüche, **dadurch gekennzeichnet, dass** die Bonddrähte (8) aus Kupfer oder einer Kupferlegierung sind.

7. Verfahren zur Herstellung eines Leistungsmoduls (1), wobei auf einen Träger (2) aus einer Keramik (3) mit einer strukturierten Metallisierung (4) mindestens ein Leistungshalbleiter (7) und mindestens ein Lastanschluss (6) angeordnet werden, wobei in einem Bondprozess mittels Bonddrähten (15) elektrische Verbindungen zwischen Elementen des Leistungsmoduls (1) hergestellt werden, wobei abschließend das Leistungsmodul (1) mit einem Isolationsmaterial (10) mindestens teilweise umhüllt wird, **dadurch gekennzeichnet, dass**
auf der strukturierten Metallisierung (4) mehrere Bonddrähte (8) angeordnet werden, wobei die Bonddrähte (8) mit beiden Enden jeweils auf einer gemeinsamen Struktur (10) der strukturierten Metallisierung (4) befestigt werden.

8. Verfahren nach Anspruch 7, **dadurch gekennzeichnet, dass** die mehreren Bonddrähte (8) im Bondprozess für die elektrischen Verbindungen gebondet werden.

9. Verfahren nach Anspruch 7 oder 8, **dadurch gekennzeichnet, dass** die mehreren Bonddrähte (8) an den äußeren Rändern (12) der strukturierten Metallisierung (4) und/oder an Kanten (14) zwischen Strukturen (9) der Metallisierung (4) angeordnet werden.

10. Verfahren nach einem der Ansprüche 7 bis 9, **dadurch gekennzeichnet, dass** die mehreren Bonddrähte (8) um Funktionselemente (13) des Leistungsmoduls (1) angeordnet werden.
